# EUROPEAN PATENT SPECIFICATION

(11) **EP 1 516 429 B1**
(45) Date of publication and mention of the grant of the patent: **07.05.2008**
(21) Application number: 03727823.1
(22) Date of filing: 27.05.2003
(51) Int. Cl.: H03J 1/00

(54) **RECEIVER AND TUNER WITH ELECTRONICALLY TUNED FILTER**
EMPFÄNGER UND ABSTIMMGERÄT MIT ELEKTRONISCH ABGESTIMMTEM FILTER
RECEPTEUR ET SYNTONISEUR AVEC FILTRE A SYNTONISATION ELECTRONIQUE

(30) Priority: 17.06.2002 EP 02077373
(43) Date of publication of application: 23.03.2005
(73) Proprietor: NXP B.V., 5656 AG Eindhoven (NL)
(72) Inventor: BREKELMANS, Johannes, H., A., NL-5656 AA Eindhoven (NL)
(74) Representative: White, Andrew Gordon
(86) International application number: PCT/IB2003/002279
(87) International publication number: WO 2003/107535

(56) References cited:
- WO-A-01/97512
- US-A- 6 005 563
- MOSHE NISSIM ET AL: "STORING AND RELOADING OF RADIO TUNING DATA" MOTOROLA TECHNICAL DEVELOPMENTS, MOTOROLA INC. SCHAUMBURG, ILLINOIS, US, vol. 25, 1 July 1995 (1995-07-01), page 120 XP000524366 ISSN: 0887-5286
- PATENT ABSTRACTS OF JAPAN vol. 2002, no. 08, 5 August 2002 (2002-08-05) & JP 2002 118522 A (SHARP CORP), 19 April 2002 (2002-04-19)

## Description

The invention relates to electronically tunable filters and more precisely to a method of calibrating such a filter in a tuner.

The tuner is for example a television tuner comprising an electronically tuned filter like for example a varicap tuned coil-capacitor tank circuit.

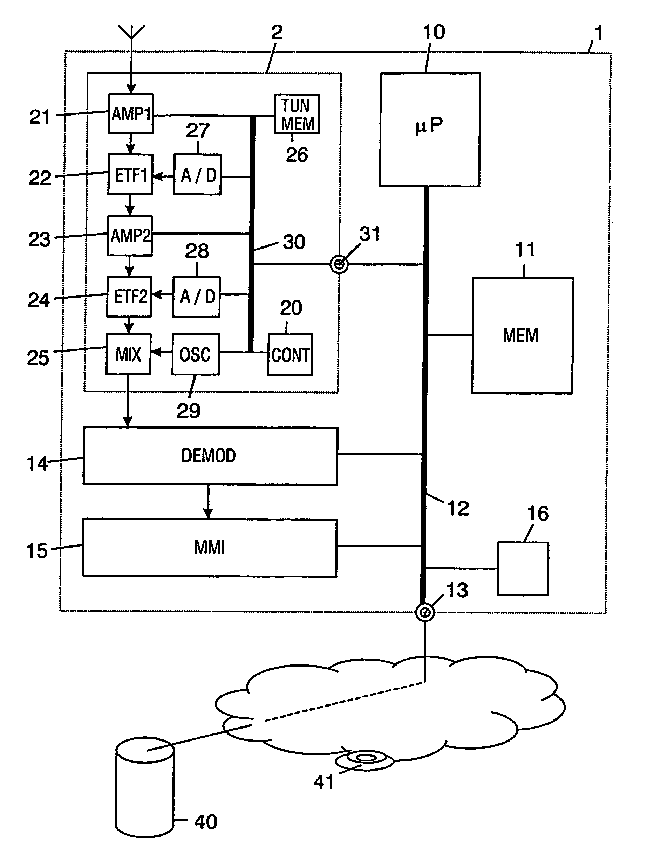

A prior art receiver is known from EP 0 540 908 A1, which discloses in its figure 1 a receiver comprising a tuner having two electronically tuned filters. The known receiver is disadvantageous, inter alia, due to not being manufacturer-friendly: tuners are usually manufactured separately from the receivers and by a first party and later installed in the receivers by a second party. The first party should take care of the calibrating (in other words: aligning), without receivers being near. In case of the tuner for example being a television tuner, the high-frequency technology does not go well with semiconductor memory technology, and the tuner does not have a memory for storing calibration signals (alignment signals). Then the second party should do the calibration process (alignment process), which is disadvantageous.

M. Nissum et, al, in "Storing and Reloading of Radio Tuning Data", Motorola Technical Developments, Motorola Inc., Shaumburg, IL, USA, vol. 25, July 1995, page 120, XP000524366, ISSN 0887-5286, disclose reading tuning data from a radio, storing the tuning data on a PC and reloading the tuning data whenever needed. A file name containing the tuning data is a unique name and includes the radio serial number.

It is an object of the invention, inter alia, to provide a receiver which is more manufacturer-friendly. The invention is defined by claim 1. The dependent claims define advantageous embodiments.

The invention is characterized in that the tuner comprises at least one identifier for identifying at least one database field in a database situated outside the receiver for storing at least one calibration signal for calibrating the electronically tuned filter.

By letting the first party do the calibration process and store the calibration signal in the database field of the database, like for example a laptop or a CD-ROM etc., the second party just needs to use the identifier to be able to download the calibration signal from the database field. This identifier for example comprises a number or a barcode etc.

The invention is based upon an insight, inter alia, that calibration of electronically tuned filters in tuners should be done directly after manufacturing and before installation of the tuners in the receivers, and is based upon a basic idea, inter alia, that calibration results do not need to be kept inside/near the tuners.

The invention solves the problem, inter alia, of providing a more manufacturer-friendly receiver, and is advantageous, inter alia, in that the manufacturing process has become more efficient. For example the high-frequency shielding encasing now no longer needs removable covers. Such removable covers were needed in the past to gain access to coils during the conventional tuner alignment procedure, in order to allow coil inductance adjustments by mechanical deformation (opening/closing of coil windings).

An exemplary receiver is advantageous in that the receiver comprises a receiver memory located outside the tuner for storing the calibration signal, with the tuner comprising a tuner bus coupled to the receiver memory for receiving the calibration signal. By using the receiver memory for storing the calibration signal, the downloading needs to be done only once for each newly installed tuner.

A further exemplary receiver is advantageous in that the database is coupled to a network, with the receiver comprising an in/output to be coupled to the network. By introducing the network, like for example the internet or an intranet (in other words for example a PSTN/ISDN network + access provider + service provider), the database can be a server, with the identifier for example comprising an Internet Protocol address or IP address and/or a Uniform Resource Locator or a URL, and the before-mentioned laptop and CD-ROM no longer need to be supplied together with the tuner. Possibly, a small semiconductor memory is located inside the tuner for storing the identifier. The in/output to be coupled to the network could for example further be used by clients for surfing the web (thereby using the receiver comprising a network modem as a personal computer) and for downloading software and for sending client information to the second party or a third party etc.

A further exemplary receiver is advantageous in that the calibration signal stored in the database and/or in the receiver memory is a digital calibration signal, with the receiver comprising a digital-to- analog converter for converting the digital calibration signal into an analog calibration signal.

By introducing the digital-to-analog converter, the calibration signals can be digitally stored and downloaded and the varicap tuned coil-capacitor tank circuit can receive analog calibration signal necessary for controlling this circuit.

A further exemplary receiver is advantageous in that the tuner comprises the digital-to-analog converter located between the tuner bus and the electronically tuned filter. By locating the digital-to-analog converter in the tuner, the digital calibration signal is supplied to the tuner and there converted into analog format, thereby giving noise outside the tuner no chance to disturb the digital calibration signal.

Aspects of the invention will be apparent from and elucidated with reference to the embodiments (s) described hereinafter.

The sole figure illustrates in block diagram form a receiver comprising a tuner.

The receiver 1 shown in the figure comprises a tuner 2, a processor (pP) 10, a memory (MEM) 11, a demodulator (DEMOD) 14, a man-machine-interface or mmi 15, and a network modem 16 all coupled to a receiver bus 12, which is further coupled to an receiver in/output 13 which is coupled to a database 40 via a network 41. An input of demodulator 14 is coupled to an output of tuner 2, and an output of demodulator 14 is coupled to an input of mmi 15 for example comprising a display or a screen, loudspeakers, an infrared interface for communication with a remote control, a keyboard or keys etc.

Tuner 2 comprises an pre-amplifier (AMP1) 21 of which an input is coupled to an antenna and of which an output is coupled to an input of a first electronically tuned filter (ETF1) 22, of which an output is coupled to an input of an further amplifier (AMP2) 23. An output of the further amplifier 23 is coupled to an input of a second electronically tuned filter (ETF2) 24, of which an output is coupled to an input of a mixer (MIX) 25. An output of mixer 25 is coupled to the input of demodulator 14, which further, for example, comprises yet further amplifiers, detectors, further filters, etc.

A control input of first electronically tuned filter 22 is coupled to an output of a first digital-to-analog converter 27 or A/D converter 27, and a control input of the second electronically tuned filter 24 is coupled to an output of a second digital-to-analog converter 28 or A/D converter 28. A control input of mixer 25 is coupled to an output of an oscillator (OSC) 29 for example comprising a synthesizer, a Phase Locked Loop or PLL etc. Control in/outputs of pre-amplifier 21, of AD converter 27, of further amplifier 23, of AD converter 28 and of oscillator 29 are coupled to a tuner bus 30, which is further coupled to a tuner memory (TUN MEM) 26 and to a bus controller (CONT) 20 and to a tuner in/output 31, which is further coupled to receiver bus 12.

The receiver 1 and the tuner 2 function as follows. Receiver 1 is for example a television receiver, with tuner 2 for example being a television tuner comprising electronically tuned filters 22,24 like for example varicap tuned coil-capacitor tank circuits. Tuner 2 has been manufactured separately from receiver 1 by a first party (a tuner manufacturer) and has been calibrated by the first party, with the calibration signals (for calibrating electronically tuned filters 22,24) however not being stored in tuner memory 26 due to tuner memory 26 either being too small for storing these calibration signals or not being there at all (semiconductor memory technology does not go well together with high- frequency technology). Later, tuner 2 is installed in receiver 1 by a second party (a receiver manufacturer).

According to a first possibility, the second party reads one or more numbers present on/near tuner 2 and/or one or more barcodes present on/near tuner 2, which numbers and/or barcodes are so-called identifiers for identifying database fields in database 40 situated outside the receiver 1. At these database fields, one or more calibration signals have been stored by the first party for calibrating the electronically tuned filters 22,24.

The second party for example connects a laptop to network 41 and downloads the calibration signals from the database fields. Then, the calibration signals are downloaded from laptop to receiver 1 via receiver in/output 13 and stored in receiver memory 11 via receiver bus 12 under control of processor 10. Then, whenever necessary, under control of processor 10, the calibration signals can be supplied via receiver bus 12 and tuner in/output 31 and tuner bus 30 to AD converters 27,28 for example under control of bus controller 20, which AD converters 27,28 convert the digital calibration signals into analog calibration signals and supply the analog calibration signals to the electronically tuned filters 22,24, which are now calibrated and which can now be used.

According to a second possibility, processor 10 decides that tuner 2 must be calibrated, and reads via receiver bus 12 and tuner in/output 31 and tuner bus 30 tuner memory 26 comprising an Internet Protocol address or IP address and/or a Uniform Resource Locator or a URL being so-called identifiers for identifying database fields in database 40 situated outside the receiver 1. At these database fields, one or more calibration signals have been stored by the first party for calibrating the electronically tuned filters 22,24.

Then processor 10 makes a connection with database 40 via network 41 and via receiver in/output 13, for example via network modem 16, with network 41 for example being the internet or an intranet (in other words, for example, a PSTN/ISDN network + access provider + service provider), and with the database for example being a server. Then, the calibration signals are automatically downloaded from database 40 via network 41 to receiver 1 via receiver in/output 13 and stored in receiver memory 11 via receiver bus 12 under control of processor 10. Then, whenever necessary, under control of processor 10, the calibration signals can be supplied via receiver bus 12 and tuner in/output 31 and tuner bus 30 to AD converters 27,28 for example under control of bus controller 20, which AD converters 27,28 convert the digital calibration signals into analog calibration signals and supply the analog calibration signals to the electronically tuned filters 22,24, which are now calibrated and which can now be used.

The invention is based upon an insight, inter alia, that calibration of electronically tuned filters 22,24 in tuners 2 should be done directly after manufacturing and before installment of the tuners 2 in the receivers 1, and is based upon a basic idea, inter alia, that calibration results do not need to be kept inside/near the tuners 2.

The invention solves the problem, inter alia, of providing a more manufacturer-friendly receiver 1, and is advantageous, inter alia, in that the manufacturing process has become more efficient. For example the high-frequency shielding encasing now no longer needs removable covers.

The receiver could further be an other kind of receiver like a car radio receiver, and the input of pre-amplifier 21 could be coupled to an antenna, a cable, a satellite antenna etc. Tuner 2 could also be used in a receiver not comprising an extensive mmi 15, like for example a set-top-box. Tuner 2 will comprise at least one electronically tuned filter or e.t. filter, but may comprise many more, up to hundreds of these e.t. filters. Then either each e.t. filter has its own identifier, or several e.t. filters share an identifier, with calibration signals comprising indications which parts of the calibration signals are destined for which e.t. filters. The content of tuner 2 is just an example, there will be at least one e.t. filter, all other parts shown like pre-amplifier 21, further amplifier 23, mixer 25 etc. may be there or not. Instead of one DA converter per e.t. filter, there could be used less DA converters in combination with a time multiplexing mechanism and/or analog buffers etc. Instead of pre- amplifier 21 being coupled to the antenna, a (further) e.t. filter could be coupled to the antenna etc. More than one tuner could be located in the same encasing, like defined in US 6,151,488 - "Multi-tuner receiver for concurrent reception of mutually different signals". Each e.t. filter could constitute, inter alia, bandpass, lowpass, highpass and bandstop type of filters and is not limited to filters for RF signals but could also constitute, inter alia, filters for IF signals or Base Band filters etc.

It should be noted that the above-mentioned embodiments illustrate rather than limit the invention, and that those skilled in the art will be able to design many alternative embodiments without departing from the scope of the invention, as defined by the appended claims. In the claims, any reference signs placed between parentheses shall not be construed as limiting the claim. The word "comprising" does not exclude the presence of elements or steps other than those listed in a claim. The word "a" or "an" preceding an element does not exclude the presence of a plurality of such elements. The invention can be implemented by means of hardware comprising several distinct elements, and by means of a suitably programmed computer. In the device claim enumerating several means, several of these means can be embodied by one and the same item of hardware. The mere fact that certain measures are recited in mutually different dependent claims does not indicate that a combination of these measures cannot be used to advantage.

## Claims

1. A method of calibrating an electronically tunable filter (22, 24) in a tuner (2), the method comprising the steps of:
calibrating the tunable filter (22, 24) to produce calibration results for the tunable filter (22, 24);
**characterised by**:
storing the calibration results in a database (40); and
applying an identifier to the tuner (2), the identifier identifying a database field in the database (40) where the calibration results are stored,
the method further comprising the subsequent steps of:
installing the tuner (2) in a receiver (1);
using the identifier on the tuner (2) to identify a database field in a database (40) situated outside said receiver (1);
downloading the calibration results from said database (40);
calibrating the tunable filter (22, 24) with calibration signals from the calibration results.

2. The method of claim 1 further comprising the step of storing the downloaded calibration results in a memory (11) in the receiver (1).

3. The method of claim 2 further comprising the steps of:
receiving the calibration signals in the tuner (2) from the receiver memory (11) via a tuner bus (30);
converting the calibration signals into analog calibration signals by a digital-to-analog converter (27, 28) in the tuner.

## Patentansprüche

1. Verfahren zum Kalibrieren eines elektronisch abstimmbaren Filters (22, 24) in einer Abstimmvorrichtung (2), wobei das Verfahren die Schritte umfasst:
Kalibrieren des abstimmbaren Filters (22, 24), um Kalibrierungsergebnisse für das abstimmbare Filter (22, 24) zu erzeugen;
**gekennzeichnet durch**:
Speichern der Kalibrierungsergebnisse in einer Datenbank (40); und
Anbringen eines Bezeichners an der Abstimmvorrichtung (2), wobei der Bezeichner ein Datenbankfeld in der Datenbank (40) bezeichnet, in dem die Kalibrierungsergebnisse gespeichert sind;
wobei das Verfahren weiter die nachfolgenden Schritte umfasst:
Installieren der Abstimmvorrichtung (2) in einem Empfänger (1);
Verwenden des Bezeichners an der Abstimmvorrichtung (2), um ein Datenbankfeld in einer Datenbank (40), die außerhalb des Empfängers (1) angeordnet ist, zu identifizieren;
Herunterladen der Kalibrierungsergebnisse von der Datenbank (40); und
Kalibrieren des abstimmbaren Filters (22, 24) mit Kalibrierungssignalen aus den Kalibrierungsergebnissen.

2. Verfahren nach Anspruch 1, das ferner den Schritt des Speicherns der heruntergeladenen Kalibrierungsergebnisse in einem Speicher (11) im Empfänger (1) umfasst.

3. Verfahren nach Anspruch 2, das ferner die Schritte umfasst:
Empfangen der Kalibrierungssignale in der Abstimmvorrichtung (2) vom Empfängerspeicher (11) über einen Abstimmvorrichtungsbus (30);
Konvertieren der Kalibrierungssignale in analoge Kalibrierungssignale mittels eines Digital-zu-Analog-Wandlers (27, 28) in der Abstimmvorrichtung.

## Revendications

1. Procédé de calibrage d'un filtre à syntonisation électronique (22, 24) dans un syntoniseur (2), le procédé comprenant les étapes consistant à :
calibrer le filtre à syntonisation (22, 24) pour produire des résultats de calibrage correspondant au filtre à syntonisation (22, 24) ;
**caractérisé par** le fait de :
stocker les résultats de calibrage dans une base de données (40) ; et
appliquer un identificateur au syntoniseur (2), l'identificateur identifiant un champ de base de données dans la base de données (40) dans laquelle les résultats de calibrage sont enregistrés,
le procédé comprenant, de plus, les étapes ultérieures consistant à :
installer le syntoniseur (2) dans un récepteur (1) ;
utiliser l'identificateur sur le syntoniseur (2) pour identifier un champ de base de données dans une base de données (40) située à l'extérieur dudit récepteur (1);
télécharger les résultats de calibrage à partir de ladite base de données (40) ;
calibrer le filtre à syntonisation (22, 24) avec des signaux de calibrage à partir des résultats de calibrage.

2. Procédé selon la revendication 1 comprenant, de plus, l'étape consistant à stocker les résultats de calibrage téléchargés dans une mémoire (11) située dans le récepteur (1).

3. Procédé selon la revendication 2 comprenant, de plus, les étapes consistant à :
recevoir les signaux de calibrage dans le syntoniseur (2) à partir de la mémoire de récepteur (11) par l'intermédiaire d'un bus de syntonisation (30) ;
convertir les signaux de calibrage en signaux de calibrage analogiques au moyen d'un convertisseur numérique/analogique (27, 28) situé dans le syntoniseur.
